# EUROPÄISCHE PATENTSCHRIFT

(11) **EP 1 618 636 B1**
(45) Veröffentlichungstag und Bekanntmachung des Hinweises auf die Patenterteilung: **22.07.2015**
(21) Anmeldenummer: 04730226.0
(22) Anmeldetag: 29.04.2004
(51) Int. Cl.: H01S 5/062, H01S 5/125

(54) **MEHRSEKTIONSLASER**
MULTISECTION LASER
LASER MULTISECTION

(30) Priorität: 30.04.2003 DE 10319817
(43) Veröffentlichungstag der Anmeldung: 25.01.2006
(73) Patentinhaber: nanoplus Nanosystems and Technologies GmbH, 97218 Gerbrunn (DE)
(72) Erfinder: REITHMAIER, Johann, Peter, 97270 Kist (DE); BACH, Lars, 01454 Ullersdorf (DE); KAISER, Wolfgang, 96138 Burgebrach (DE)
(86) Internationale Anmeldenummer: PCT/EP2004/004555
(87) Internationale Veröffentlichungsnummer: WO 2004/098005

(56) Entgegenhaltungen:
- EP-A- 0 825 689
- FEISTE U: "OPTIMIZATION OF MODULATION BANDWIDTH IN DBR LASERS WITH DETUNED BRAGG REFLECTORS" IEEE JOURNAL OF QUANTUM ELECTRONICS, IEEE INC. NEW YORK, US, Bd. 34, Nr. 12, Dezember 1998 (1998-12), Seiten 2371-2379, XP000799031 ISSN: 0018-9197
- CHOI W-Y ET AL: "EVALUATION OF COUPLING COEFFICIENTS FOR LATERALLY-COUPLED DISTRIBUTED FEEDBACK LASERS" JAPANESE JOURNAL OF APPLIED PHYSICS, PUBLICATION OFFICE JAPANESE JOURNAL OF APPLIED PHYSICS. TOKYO, JP, Bd. 35, PART 1, Nr. 9A, 1. September 1996 (1996-09-01), Seiten 4654-4659, XP000735383 ISSN: 0021-4922
- LOURTIOZ J M ET AL: "FOURIER-TRANSFORM-LIMITED PULSES FROM GAIN-SWITCHED DISTRIBUTED-BRAGG-REFLECTOR LASERS USING SIMULTANEOUS MODULATION OF GAIN AND PHASE SECTIONS" ELECTRONICS LETTERS, IEE STEVENAGE, GB, Bd. 28, Nr. 16, 30. Juli 1992 (1992-07-30), Seiten 1499-1500, XP000309693 ISSN: 0013-5194
- MARCENAC D D ET AL: "Theory of enhanced amplitude modulation bandwidth in push-pull modulated DFB lasers" IEEE PHOTONICS TECHNOL. LETT. (USA), IEEE PHOTONICS TECHNOLOGY LETTERS, NOV. 1994, USA, Bd. 6, Nr. 11, November 1994 (1994-11), Seiten 1309-1311, XP002292281 ISSN: 1041-1135
- BACH L ET AL: "22 GHz direct-modulated weakly coupled DBR-laser fabricated by focused ion beam lithography" INTERNATIONAL CONFERENCE ON INDIUM PHOSPHIDE AND RELATED MATERIALS 2003, 12. Mai 2003 (2003-05-12), Seiten 190-193, XP002292282 IEEE, PISCATAWAY, NJ, USA ISBN: 0-7803-7704-4
- VAHALA K ET AL: "OBSERVATION OF MODULATION SPEED ENHANCEMENT, FREQUENCY MODULATION SUPPRESSION, AND PHASE NOISE REDUCTION BY DETUNED LOADING IN A COUPLED-CAVITY SEMICONDUCTOR LASER" APPLIED PHYSICS LETTERS, AMERICAN INSTITUTE OF PHYSICS. NEW YORK, US, Bd. 46, Nr. 11, 1. Juni 1985 (1985-06-01), Seiten 1025-1027, XP000706625 ISSN: 0003-6951
- KJEBON O ET AL: "Experimental evaluation of detuned loading effects on distortion in edge emitting DBR lasers" INTERNATIONAL TOPICAL MEETING ON MICROWAVE PHOTONICS, TECHNICAL DIGEST, 5. November 2002 (2002-11-05), Seiten 125-128, XP010623137 IEICE, TOKYO, JAPAN ISBN: 4-88552-187-4
- VAHALA K ET AL: "Detuned loading in coupled cavity semiconductor lasers-Effect on quantum noise and dynamics" APPL. PHYS. LETT. (USA), APPLIED PHYSICS LETTERS, 1 SEPT. 1984, USA, Bd. 45, Nr. 5, 1. September 1984 (1984-09-01), Seiten 501-503, XP002292283 ISSN: 0003-6951

## Beschreibung

Die Erfindung betrifft einen Halbleiterlaser mit hoher Modulationsbandbreite. Weiterhin betrifft die Erfindung ein Verfahren zum Betrieb eines Halbleiterlasers.

Halbleiterlaser werden heutzutage für unterschiedlichste Anwendungen in der Technik eingesetzt.

Eines dieser Einsatzgebiete liegt in der Kommunikationstechnologie.

Dabei werden Informationen wie Sprache, bewegte und unbewegte Bilder oder Computerdaten zunächst in elektrische Signale umgewandelt, soweit sie nicht bereits als solche vorliegen. Die elektrischen Signale werden anschließend zur Modulation der Helligkeit einer Lichtquelle verwendet.

Die so erhaltenen Lichtsignale können anschließend beispielsweise durch Glasfasern an ein Empfangsgerät übermittelt werden. Das Empfangsgerät wandelt die empfangenen Lichtsignale in elektrische Signale um. Gegebenenfalls werden die so erhaltenen elektrischen Signale weiter umgewandelt.

Bei einer Übertragung überlängere Wegstrecken sind gegebenenfalls auch zwischengeschaltete Verstärker erforderlich. Diese wandeln nach dem heutigen Stand der Technik die Lichtsignale üblicherweise zunächst in elektrische Signale um, die verstärkt werden und anschließend von einer modulierten Lichtquelle erneut ausgesandt werden.

Die beschriebene Datenübertragung mittels Lichtsignalen wird nicht nur für die Überbrückung größerer Entfernungen eingesetzt, sondern findet mittlerweile auch für den Einsatz bei lokalen Computernetzwerken (LAN - Local Area Network) Anwendung, und zwar nicht zuletzt aufgrund der großen erreichbaren Übertragungsraten.

Um einen möglichst großen Datendurchsatz bei der Übertragungsstrecke erzielen zu können, ist es naturgemäß von Vorteil, wenn die verwendeten modulierbaren Lichtquellen eine möglichst große Modulationsbandbreite aufweisen. Im Übrigen ist unter dem Begriff Licht nicht nur das sichtbare Spektrum zu verstehen, sondern insbesondere auch der Infrarotbereich.

Aufgrund ihrer Eigenschaften eignen sich Halbleiterlaser hervorragend für den Einsatz als modulierbare Lichtquelle bei Kommunikationsanwendungen. So weisen Halbleiterlaser eine kleine Baugröße auf, sind relativ kostengünstig in der Herstellung und weitgehend unempfindlich gegenüber Umwelteinflüssen (insbesondere gegenüber Stößen).

Die Modulationsbandbreite von Halbleiterlasern ist jedoch nach wie vor ein Problem. So weisen übliche Halbleiterlaser eine maximale Modulationsbandbreite im Bereich von lediglich 10 GHz, und damit eine maximale Übertragungsrate im Bereich von 10 GBit/s auf.

Die genannten Übertragungsraten resultieren aus den intrinsischen Hochfrequenzeigenschaften von Halbleiterlasern, die im Wesentlichen von dem Material- und Schichtstruktureigenschaften bzw. durch Betriebsparameter; wie z. B. dem Injektionsstrom bestimmt werden.

Eine wesentliche Begrenzung der Modulationsbandbreite eines Halbleiterlasers beruht auf der Rekombinationszeit der Ladungsträger in der aktiven Schicht. Diese Rekombinationszeit hängt ab von den Materialeigenschaften und der Wechselwirkungsstärke des Elektronen-Loch-Übergangs mit dem elektromagnetischen Strahlungsfeld in der Laserkavität. Die entsprechende Zeitkonstante gibt an, wie schnell die ausgekoppelte Lichtleistung auf Änderungen der induzierten Ladungsträgerdichte, also dem Modulationsstrom, reagiert. Da die Rekombinationszeit der Ladungsträger vor allem von den Materialien in der aktiven Schicht abhängt, ist eine Erhöhung der maximalen Modulationsbandbreite nur bedingt möglich.

So konnten teilweise Verbesserungen bei der Modulationsbandbreite dadurch erzielt werden, dass die Laserfacetten der Halbleiterlaser antireflex vergütet, bzw. hochreflex vergütet wurden, oder dass sehr kurze Bauelementlängen, durch die man die Photonenlebensdauer in der Kavität reduziert, vorgesehen wurden. Diese Maßnahmen haben jedoch ihrerseits zum Nachteil, dass die Schwellenstromdichte erheblich zunimmt, und die Ausgangsleistung stark begrenzt ist. Um die Ausgangsleistung nicht zu stark abfallen zu lassen, wurde wiederum versucht, die differenzielle Verstärkung (dg/dN mit g als Materialverstärkung und N als Ladungsträgerdichte) zu erhöhen, indem man beispielsweise das aktive Volumen durch einen Stapel von Quantenfilmschichten erheblich erhöht. Weiterhin kann die Rekombinationszeit der Ladungsträger z.B. durch eine p-Dotierung der aktiven Zone reduziert werden.

In jedem Fall wird bei den beschriebenen Maßnahmen die Schwellenstromdichte erheblich erhöht und die Lasereigenschaften verschlechtern sich deutlich. Die mit den beschriebenen Maßnahmen bislang erzielten Rekordwerte liegen bei ca. 33 GHz für Laser mit einer Emissionswellenlänge im Bereich von 1,5 µm.

Aufgrund der ungünstigen Randbedingungen werden daher direkt modulierte Halbleiterlaser momentan nur für Übertragungsraten von bis zu ca. 10 GBit/s eingesetzt.

Um höhere Bitraten zu ermöglichen, wurde bereits versucht, das Problem der begrenzten intrinsischen Bandbreite von Halbleiterlasern dadurch zu umgehen, dass externe Modulatoren verwendet werden. Damit wurden bereits Bandbreiten von bis zu 40 GHz erzielt. Diese Technologie ist jedoch sehr aufwändig (es werden mehrere hybrid aufgebaute optoelektronische Komponenten benötigt) und dementsprechend kostenintensiv.

Der Erfindung liegt daher die Aufgabe zugrunde, einen Halbleiterlaser vorzuschlagen, der eine hohe Modulationsbandbreite aufweist, ohne dass sich die Betriebsparameter wesentlich verschlechtern, und der dennoch relativ einfach und kostengünstig in der Herstellung ist.

Der vorgeschlagene Halbleiterlaser sowie das vorgeschlagene Verfahren zum Betrieb von Halbleiterlasern gemäß der unabhängigen Ansprüche lösen die Aufgabe.

Vorteilhafte Weiterbildungen des Halbleiterlasers bzw. des Verfahrens sind in den abhängigen Ansprüchen beschrieben.

Um einen Halbleiterlaser mit hoher Modulationsbandbreite zu erhalten, wird vorgeschlagen, dass ein Halbleiterlaser mit einem Substrat und beim Substrat drei voneinander unabhängige Funktionssektionen in Richtung der Lichtwellenausbreitungsrichtung vorgesehen sind. Als Funktionssektionen kommen dabei insbesondere eine Verstärkungszone (Besetzungszahlinversion durch pumpen), eine Gitterzone und eine Phasenanpassungszone in Betracht. Es wird daraufhingewiesen, dass unter Lichtwellen nicht nur Licht mit Wellenlängen im sichtbaren Teil des Spektrums zu verstehen ist. Insbesondere kommen auch Infrarotwellen in Betracht.

Durch die voneinander unabhängigen Sektionen, die jeweils einer unterschiedlichen Funktion dienen, ist es möglich, die einzelnen Aufgaben jeweils optimal einzustellen, ohne dass die optimale Einstellung der einen Aufgabe einen negativen Einfluss auf die Anpassung einer anderen Aufgabe mit sich zöge. Somit sind nicht nur die einzelnen Anpassungsaufgaben jeweils für sich optimal lösbar, sondern es ist insbesondere auch möglich, dass die einzelnen Aufgaben derart angepasst werden, dass sich ein weitgehend optimaler synergetischer Effekt ergibt. Insbesondere kann durch eine entsprechende Einstellung einer Gitterzone, bzw. einer Kopplungszone eine hinsichtlich der Bandbreite des Halbleiterlasers optimale Kopplung der verbliebenen Sektionen miteinander erreicht werden, sodass eine weitgehend optimale Kopplung zwischen Elektron-Photon-Resonanz (Wechselwirkung des Elektron-LochÜbergangs mit dem elektromagnetischen Strahlungsfeld in der Laserkavität) und der Photon-Photon-Resonanz erzielbar ist. Durch dieses neue Designkonzept kann die Dämpfung der Elektron-Photon-Resonanz erheblich reduziert werden, und die Bandbreite des Halbleiterlasers (-3 dB-Bandbreite) zu wesentlich höheren Werten verschoben werden.

Trotz der erzielbaren, besonders hohen Modulationsbandbreite weist der vorgeschlagene Halbleiterlaser nicht notwendigerweise die bislang mit einer Modulationsbandbreitenerhöhung einhergehenden negativen Effekte wie Erhöhung der Schwellenstromdichte und Verringerung der Ausgangsleistung aus.

Es sind unterschiedliche Ansätze zur Erhöhung der Modulationsbandbreite bei direkt modulierten Halbleiterlasern bekannt. So wurde beispielsweise unter Verwendung eines DBR Lasers bestehend aus einem aktiven Segment mit passivem Bragg Reflektor [U Feiste, Optimization of modulation bandwidth in DBR lasers with detuned Bragg grating, IEEE Journal of Quantum Electronics, Band 34, Nr. 12, Seiten 2371-2379 (1998)] eine Modulationsbandbreitenerhöhung erzielt. Ein solcher Ansatz beinhaltet jedoch verschiedene Nachteile. Beispielsweise ist hier der Einsatz kurzer effektiver Kavitätslängen im Bereich weniger hundert µm erforderlich um einen großen Fabry-Perot Modenabstand zu erreichen. Daraus resultieren negative Effekte wie beispielsweise eine Verringerung der Ausgangsleistung. Zusätzlich kann bei einem solchen Bauelement die Phasenlage nicht getrennt von Kopplungs-, Dämpfungs- und Pumpeigenschaften eingestellt werden. Die hier vorliegende Erfindung beruht auf einem anderen Prinzip. Sowohl der Aufbau, wie auch das vorgeschlagene Verfahren zum Betrieb des Lasers mit erhöhter Modulationsbandbreite sind unterschiedlich und umgehen die obengenannten Nachteile.

Der vorgeschlagene Halbleiterlaser insbesondere für Bauteillängen von mehr als 1,0 mm weist nicht notwendigerweise die bislang mit einer Modulationsbandbreitenerhöhung einhergehenden negativen Effekte wie Erhöhung der Schwellenstromdichte und Verringerung der Ausgangsleistung auf. Hierzu wird ein Mehrsegmentlaser vorzugsweise mit Bauteillänge von mehr als 1,0 mm sowie ein neuartiges Verfahren zum Betrieb dieses Lasers vorgeschlagen, mit dem eine besonders hohe Modulationsbandbreite erzielt werden kann. Dabei werden unterschiedliche Aufgaben, wie insbesondere Verstärkung, Phasenanpassung, Wellenlängenselektion und/oder Dämpfung, in wenigstens drei von einander unabhängigen Sektionen des Halbleiterlasers durchgeführt, wobei eine weitgehend optimale Kopplung zwischen Elektron-Photon-Resonanz und Photon-Photon-Resonanz des Halbleiterlasers erfolgt.

Bei Distributed Feedback (DFB) Lasern mit zweigeteilter Kontaktstrukur ist das Verfahren der sogenannten "push-pull Modulation" bekannt, um die Modulationsbandbreite über die Grenze der Elektron-Photon-Resonanz hinaus zu erhöhen. Dies geschieht durch eine inhomogene Strominjektion in die zwei Kontakte des DFB Lasers [D D Marcenac et al., "Therory of enhanced amplitude modulation bandwidth in push-pull modulated DFB lasers", IEEE PHOTONICS TECHNOLOGY LETTERS, NOV. 1994, Bd. 6, Nr. 11, Seiten 1309-1311].

Im Unterschied dazu weist der vorgeschlagene Halbleiterlaser wenigstens drei voneinander unabhängige Funktionssektionen auf und ermöglicht damit eine optimale Kopplung zwischen Elektron-Photon-Resonanz und Photon-Photon-Resonanz, was bei einem Zweisektions- oder Einsektions-Design nur sehr eingeschränkt möglich ist.

Mehrsegmentlaser mit andersartigem Aufbau und mit andersartigen Verfahren zum Betrieb dieser Mehrsegmentlaser werden für unterschiedlichste Aufgabenstellungen eingesetzt. So wurde beispielsweise ein Bauelement vorgeschlagen [EP 0 825 689 A (CANON KK) 25. Februar 1998 (1998-02-25)] bei dem die Ausgangsintensität von Licht vorgegebener Polarisationsrichtung durch ein Modulationssignal gesteuert werden kann. Mit diesem Verfahren kann der sogenannte ,chirp' eines Halbleiterlasers unterdrückt werden. Dies geschieht durch ein Umschalten zwischen zwei Zuständen unterschiedlicher Polarisation, wozu Licht einer Bragg-Wellenlänge und einer Fabry-Perot Resonanz (mit jeweils unterschiedlicher Polarisation) genutzt wird. Die vorliegende Erfindung beruht auf einem anderen Prinzip. Durch den hier vorgeschlagenen Mehrsegmentlaser sowie das vorgeschlagene Verfahren zum Betrieb dieses Mehrsegmentlasers wird eine Kopplung zwischen Elektron-Photon-Resonanz und Photon-Photon-Resonanz erzielt, woraus eine Modulationsbandbreitenerhöhung resultiert.

Das genannte Designkonzept schließt im Übrigen nicht aus, dass eine Funktionssektion zwei Funktionen übernehmen kann. So kann insbesondere die Gitterzone, die der Wellenlängenselektion dient, gleichzeitig als Kopplungselement zwischen Verstärkungszone und Phasenanpassungszone dienen.

Wenn das Substrat des Halbleiterlasers als Monolith ausgebildet ist, kann ein besonders einfacher Herstellungsprozess ermöglicht werden. Darüber hinaus kommt es in der Regel zu keinen unerwünschten Reflektionen oder Phasensprüngen beim Übergang zwischen unterschiedlichen Substratbereichen. Gegebenenfalls sind entsprechende Impedanzanpassungsübergänge vorzusehen.

Von Vorteil ist es, wenn bei dem Halbleiterlaser wenigstens ein Wellenleiterbereich vorgesehen ist. Dadurch kann eine definierte Ausbreitung der Lichtwelle im Halbleitersubstrat ermöglicht werden. Gegebenenfalls können unterschiedliche Bereiche des Wellenleiters mit einer unterschiedlichen Wellenlängendispersion (auch bezüglich des Vorzeichens) versehen werden, sodass Wellenpakete über die Gesamtlänge des Halbleiterlasers hin eine möglichst geringe Dispersion zeigen.

Wenn die einzelnen Funktionssektionen im Wesentlichen jeweils nur eine Funktion ausüben, kann die Anpassung der einzelnen Punktionen nochmals verbessert werden.

Wenn bei dem Halbleiterlaser eine Gitterzone, eine Kopplungszone, oder beides (wobei es sich auch um eine kombinierte Gitter- und Kopplungszone handeln kann) zwischen einer Verstärkungszone und einer Phasenanpassungszone liegend angeordnet sind, kann eine vorteilhafte Kopplung zwischen Verstärkungszone und Phasenanpassungszone gefördert werden. Dies resultiert üblicherweise in einer besonders großen Modulationsbandbreite.

Als besonders vorteilhaft erweist es sich, wenn die Gitterzone eine nur schwache Kopplung zwischen Lichtwelle A und Gitterstruktur aufweist. Dabei wird insbesondere ein Kopplungskoeffizient κ von κ ≤ 60 cm⁻¹, vorzugsweise zwischen κ = 10 cm⁻¹ und κ = 50 cm⁻¹, besonders vorzugsweise zwischen κ = 20 cm⁻¹ und κ = 40 cm⁻¹ vorgeschlagen. Durch die nur schwache Kopplung bleibt die Durchlässigkeit der Lichtwelle durch die Gitterzone gewahrt, was insbesondere dann von Bedeutung ist, wenn die Gitterzone wie oben beschrieben der Verstärkungszone und der Phasenanpassungszone zwischenliegend angeordnet ist. Weiterhin ist es durch die nur schwache Kopplung möglich, dass durch das Vorsehen einer entsprechenden Anzahl von Gitterstrukturelementen auf einfache Weise die Filterkurve der Gitterzone ausreichend selektiv, jedoch auch nicht zu selektiv gewählt werden kann.

Wenn eine aktive Gitterzone, eine aktive Kopplungszone oder beides vorgesehen sind, also die Kopplung zwischen Lichtwelle und Gitterstruktur, die Dämpfungs- bzw. die Kopplungseigenschaften (Kopplung durch die betreffende Sektion hindurch) der betreffenden Zone veränderlich sind, kann eine optimale Anpassung der einzelnen Funktionssektionen aufeinander nochmals gefördert werden. Dabei kann es vorkommen, dass bei Anpassung einer aktiven Zone die Veränderung der einen Eigenschaft (z.B. der Kopplung zwischen Lichtwelle und Gitterstruktur) eine Veränderung einer anderen Eigenschaft (z.B. der Dämpfung der Lichtwelle beim Durchlaufen des Gitters) mitbedingt.

Es hat sich als vorteilhaft erwiesen, wenn das Gitter so ausgebildet wird, dass die Gitterstrukturen lateral zum Wellenleiterbereich ausgebildet sind. Damit lässt sich insbesondere eine nur schwache Kopplung zwischen Lichtwelle und Gitterstruktur besonders leicht erzielen. Vorteilhaft ist es auch, wenn der Halbleiterlaser eine bei konventionellen Halbleiterlasern übliche Bauteillänge aufweist, insbesondere eine Bauteillänge von mehr als 0,5 mm, vorzugsweise von mehr als 0,8 mm, besonders vorzugsweise von mehr als 1,0 mm. Dadurch kann es vermieden werden, eine übermäßig hohe differentielle Stromverstärkung dg/dN vorsehen zu müssen, was zu entsprechend nachteiligen Betriebsparametern führen konnte. Insbesondere können übermäßige Injektionsstromstärken sowie eine nur begrenzte Laserausgangsleistung vermieden werden.

Dem Erfindungsgedanken folgend wird weiterhin ein Verfahren zum Betrieb eines Halbleiterlasers vorgeschlagen, mit dem eine besonders hohe Modulationsbandbreite erzielt werden kann. Dazu wird vorgeschlagen, dass unterschiedliche Aufgaben, wie insbesondere Verstärkung (Besetzungszahlinversion durch Pumpen), Phasenanpassung, Wellenlängenselektion und/oder Dämpfung, in wenigstens drei voneinander unabhängigen Sektionen längs des Substratmaterials des Halbleiterlasers durchgeführt werden. Das Verfahren weist die im Zusammenhang mit dem vorgeschlagenen Halbleiterlaser genannten Vorteile in analoger Weise auf.

Das vorgeschlagene Verfahren lässt sich besonders vorteilhaft weiterbilden, wenn eine Anpassung der einzelnen Sektionen dahingehend durchgeführt wird, dass eine weitgehend optimale Kopplung zwischen Elektron-Photon-Resonanz und Photon-Photon-Resonanz des Halbleiterlasers erfolgt. Eine besonders große Modulationsbandbreite des Halbleiterlasers kann somit nochmals gefördert werden.

Von Vorteil ist es auch, wenn der Halbleiterlaser auf der langwelligen Seite des Reflexionspeaks betrieben wird. Dadurch lässt sich insbesondere auch ein Chirp (also eine Frequenzmodulation des Halbleiterlasers infolge einer veränderten Amplitude) auf einfache Weise vermindern, da in diesem Fall die Modulation des optischen Brechungsindexes normalerweise am geringsten ist. Da ein Frequenz-Chirp aufgrund der Dispersion einer anschließenden Glasfaser zu einer zeitlichen Überlagerung der Pulse nach einer bestimmten Übertragungsstrecke führt, kann durch die vorgeschlagene Weiterbildung eine nochmals erhöhte Übertragungsrate realisiert werden.

Ein zu bevorzugendes Ausführungsbeispiel der Erfindung wird im Folgenden unter Bezugnahme auf die Figur näher beschrieben.

Es zeigen:
- **Fig. 1**: einen Designvorschlag für einen Halbleiterlaser mit 3 Sektionen von der Seite aus gesehen;
- **Fig. 2**: einen Querschnitt durch den in **Fig.1** gezeigten Halbleiterlaser längs der Achse II-II;
- **Fig. 3**: die Gitterstruktur des in **Fig.1** gezeigten Halbleiterlasers in schematischer Darstellung in Draufsicht von oben;
- **Fig. 4**: ein typisches Leistungsverhalten für einen Halbleiterlaser in Abhängigkeit von der Modulationsfrequenz;
- **Fig. 5**: typische Messergebnisse für einen Prototyp eines vorgeschlagenen Halbleiterlasers mit 3 Sektionen.

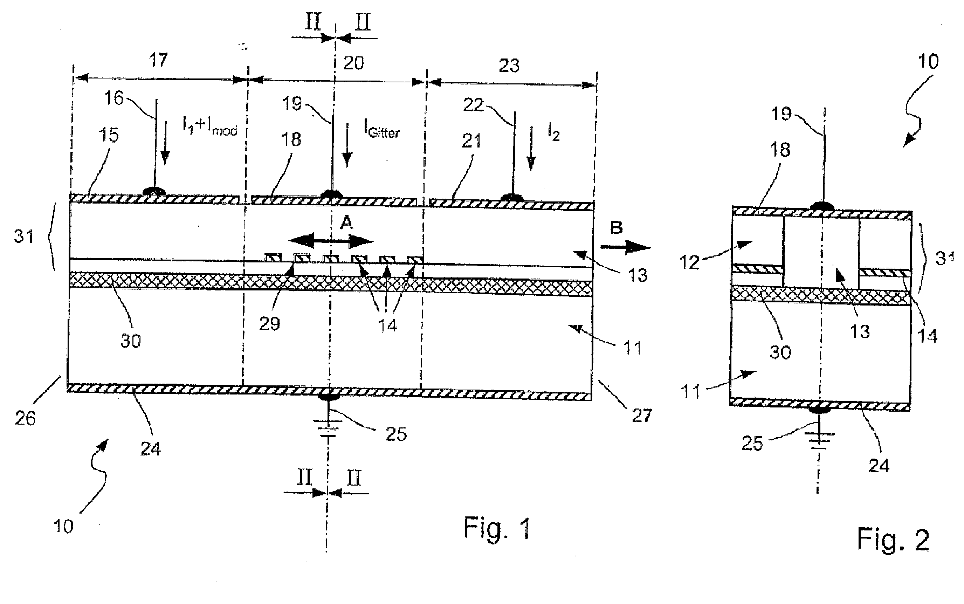

In **Fig.1** ist ein möglicher Designvorschlag einer Halbleiterlaserdiode 10 dargestellt, bei der die Halbleiterlaserdiode 10 eine hohe Modulationsbandbreite 28 aufweist. Das vorgeschlagene Strukturprinzip stellt einen sogenannten CCIG-Laser (für "coupled cavity injection grating") dar.

Die Grundstruktur der vorliegend dargestellten Halbleiterlaserdiode 10 besteht in üblicher Weise aus einem dotierten Mehrschichtsystem auf Substratmaterial 11 und einem entgegengesetzt dotierten Mehrschichtsystem als Deckschicht 31. Im Übergangsbereich des Dotierwechsels ist eine Ladungsträger-Rekombinationszone aus einer oder mehreren Schichten 30 eingebettet, die für die optische Verstärkung der Halbleiterlaserdiode 10 sorgt. Diese Schichten können aus Volumenhalbleitermaterial, Quantenfilmstrukturen, Quantendrahtstrukturen oder Quantenpunktstrukturen bestehen. Als Halbleitermaterialien kommen üblicherweise III/V-bzw. II/VI-Halbleitermaterialien zum Einsatz, wie bspw. Galliumarsenid (GaAs), Indiumphosphid (InP) oder komplexere Verbindungshalbleiter wie z.B. GalnAsP, GalnAs oder AlGaAs. Als Dotierstoffe werden häufig Dotiermaterialien wie Beryllium (Be), Kohlenstoff (C) oder Silizium (Si) verwendet.

Beim vorliegend beschriebenen Bauteil ist ein Streifenwellenleiter 13 vorgesehen, der seitlich durch ein anorganisches oder organisches Isolationsmaterial 12 umgeben ist. In der Regel werden ein Polymer oder dielektrische Materialien mit geringer Dielektrizitätskonstante eingesetzt, um die Kontaktkapazitäten gering zu halten. Die in **Fig.1** eingezeichnete gestrichelte Linie soll die Längserstreckung des Wellenleiterbereichs 13 verdeutlichen.

An den beiden Stirnflächen der Halbleiterlaserdiode 10 sind Laserfacetten 26 und 27 angeordnet, die in üblicher Weise verspiegelt bzw. teilverspiegelt sind. Zwischen den beiden Laserfacetten 26 und 27 wird somit eine Laserkavität gebildet. Im dargestellten Ausführungsbeispiel ist die erste Laserfacette 26 vollverspiegelt, während die zweite Laserfacette 27 teilverspiegelt ist, sodass an der zweiten Laserfacette 27 optische Energie, wie insbesondere Licht, in Richtung des Pfeils B ausgekoppelt wird.

Im dargestellten Ausführungsbeispiel der Halbleiterlaserdiode 10 ist weiterhin ein Wellenleiterbereich 13 vorgesehen, längs dem die elektromagnetische Welle in der Laserkavität verläuft. Dies ist durch den Doppelpfeil A angedeutet.

Dem Erfindungsgedanken folgend ist die in den Figuren exemplarisch dargestellte Halbleiterlaserdiode 10 in drei Sektionen 17, 20, 23 aufgeteilt. In jeder Sektion ist eine eigene, von den anderen Elektroden elektrisch isolierte Elektrode 15, 18, 21 mit jeweils einer eigenen Zuleitung 16, 19, 22 vorgesehen. Auf der den Elektroden 15, 18, 21 gegenüberliegenden Seite befindet sich eine einzelne, flächig aufgebrachte Masseelektrode 24 mit einer dieser zugeordneten Masseleitung 25. Selbstverständlich ist es ebenso möglich, dass auch die Masseelektrode 24 in zwei oder mehrere Teilbereiche unterteilt wird. Weiterhin kann die Masseelektrode 24 auch auf ein anderes, geeignetes Potential gesetzt werden.

Bei der dargestellten Halbleiterlaserdiode 10 dienen die unterschiedlichen Sektionen 17, 20, 23 jeweils unterschiedlichen Aufgaben.

So dient die erste Sektion 17 als Verstärkungs- und Modulationszone 17. Über die erste Zuleitung 16 wird der ersten Elektrode 15 der Injektionsstrom I₁ sowie der Modulationsstrom I_{mod} zugeführt. Der Injektionsstrom I₁ bewirkt die Besetzungszahlinversion (Pumpen der Besetzungszustände). I₁ ist dabei ein Gleichstrom, der derart gewählt wird, dass er in beiden Richtungen variiert werden kann, ohne dass die Laserstrahlung abbricht. Der Laser kann also stärker und schwächer strahlen. Zur Variation der Laserausgangsleistung P dient der Modulationsstrom I_{mod}. I_{mod} wird entsprechend dem zu übertragenden Kommunikationssignal gewählt und kann beispielsweise digital in Form von unterschiedlich langen Impulsen oder aber auch als Analogsignal mit unterschiedlich hoher Amplitude vorliegen. Der der ersten Elektrode 15 zugeführte Gesamtstrom I₁ + I_{mod} ist somit in der Regel ein Gleichstrom mit einem aufgelagerten Wechselstromanteil.

Insbesondere beim Vorliegen digitaler Signale ist es selbstverständlich auch möglich, dass I₁ knapp unterhalb der Laserschwelle gewählt wird, sodass I_{mod} die Halbleiterlaserdiode 10 entsprechend seiner Taktung über die Laserschwelle bringt.

Die zweite Sektion 20 dient als Gitterzone 20, wobei in vorliegendem Ausführungsbeispiel das Gitter 29 als aktives Gitter 29 ausgeführt ist. Zur Steuerung des Gitters 29 ist im Bereich der Gitterzone 20 eine zweite Elektrode 18 mit einer entsprechenden Zuleitung 19 vorgesehen.

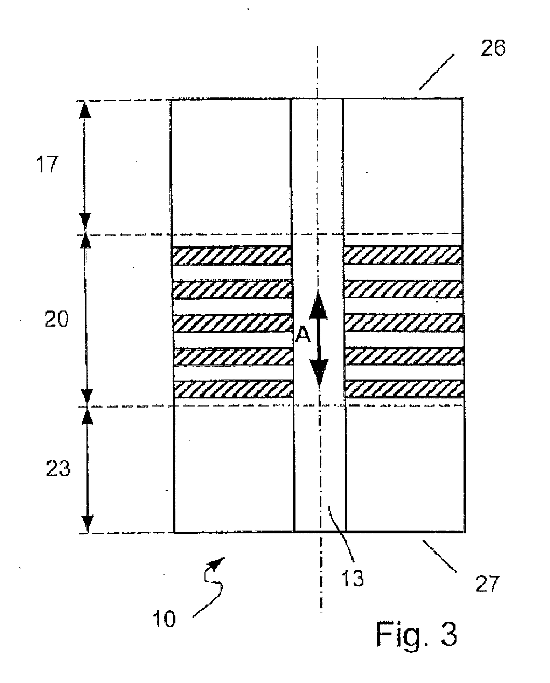

Das Gitter 29, das der Wellenlängenselektion der Halbleiterlaserdiode 10 dient, ist im vorliegenden Ausführungsbeispiel als sogenanntes DBR-Gitter (für "distributed bragg reflector") ausgebildet, wobei die einzelnen Gitterstrukturelemente 14 als lateral zum Wellenleiterbereich 13 ausgebildete Gitterstrukturelemente 14 ausgebildet sind (siehe auch **Fig. 2** und **Fig. 3**). Der Aufbau hat den Vorteil, dass die Kopplung zwischen Lichtwelle und Gitter 29 schwach ist, sodass eine Vielzahl von Gitterstrukturelementen 14 zur Interferenz beiträgt, und das Gitter 29 nach wie vor für die optische Strahlung durchlässig ist. Das Gitter 29 kann somit, wie im vorliegenden Ausführungsbeispiel, in der Mitte zwischen Verstärkungszone 17 und Phasenanpassungszone 23 (dritte Sektion) ausgebildet werden. Die Gitterstrukturelemente 14 können in beliebiger Weise, wie durch Materialauftrag, Materialabtrag oder Dotierung, ausgebildet werden. Im vorliegend beschriebenen Ausführungsbeispiel wurde die Gitterstruktur durch einen fokussierten lonenstrahl eingeprägt. Die Kopplungsstärke κ sollte im Bereich von κ ≤ 60 cm⁻¹, vorzugsweise zwischen κ = 10 cm⁻¹ und κ = 50 cm⁻¹, besonders vorzugsweise zwischen κ = 20 cm⁻¹ und κ = 40 cm⁻¹ gewählt werden. Als Mindestwert sollten in jedem Fall einige cm⁻¹ als Mindestkopplungsstärke κ vorgesehen werden.

Durch den der Gitterzone 20 über die zweite Elektrode 18 zugeführten Gitterstrom I_{Gitter} können die Dämpfungseigenschaften der Gitterzone 20 verändert werden und damit die Gitterzone 20 als anpassbares Koppelelement zwischen Verstärkungszone 17 und Phasenanpassungszone 23 dienen. Dadurch ist es möglich, die Kopplung zwischen diesen beiden Sektionen, und damit die Kopplungsstärke zwischen Elektron-Photon-Resonanz und Photon-Photon-Resonanz optimal anzupassen.

Die dritte Sektion 23 dient als Phasenanpassungszone 23. Dazu kann über die dritte Zuleitung 22 und die dritte Elektrode 21 der Phasenanpassungszone 23 der Halbleiterlaserdiode 10 ein Phasenanpassungsstrom I₂ zugeführt werden. Durch den Strom I₂ kann durch eine Erhöhung bzw. Absenkung der freien Ladungsträger die optische Dichte in der dritten Sektion 23 erhöht bzw. abgesenkt werden und so die geometrische Länge der Kavität für die Lichtwelle verlängert bzw. verkürzt werden. Dadurch kann die Phasenlage für die Photon-Photon-Resonanz optimal angepasst werden.

Bei optimaler Einstellung der Phase liegt die Emissionswellenlänge auf der langwelligen Seite des Reflexionspeaks. Dieses Verfahren der Verstellung der Emissionswellenlänge auf die langwellige Seite des Reflexionspeaks des Gitters wird auch als "detuned loading" bezeichnet. Die Elektron-Photon-Resonanz ist dann mit der schnelleren Photon-Photon-Resonanz gekoppelt.

Durch das Vorsehen von vorliegend drei Sektionen 17, 20, 23, die jeweils unterschiedlichen Anpassungsaufgaben dienen, können die einzelnen Anpassungen (hier Pumpen/Verstärkung, Dämpfung/Wellenlängenselektion und Phasenanpassung) unabhängig von den anderen Anpassungsaufgaben gewählt werden und damit optimal aufeinander angepasst werden. Dies wäre bei einem Zweisektions-Design - oder gar bei einem Einsektions-Design - nur eingeschränkt möglich, da die Phasenlage nicht getrennt von Kopplungs-, Dämpfungs- und Pumpeigenschaften eingestellt werden könnte. Die optimale Anpassung der einzelnen Größen ermöglicht es jedoch, die Photon-Photon-Resonanz optimal auszunutzen und ebenfalls die Kopplungsstärke zwischen Elektron-Photon-Resonanz und Photon-Photon-Resonanz optimal einzustellen.

Die dargestellte Halbleiterlaserdiode 10 kann selbstverständlich auch mit diversen Variationen aufgebaut werden. So können beispielsweise größere passive Bereiche (ohne Elektroden) zwischen den Sektionen 17, 20, 23 vorgesehen werden. Auch kann ein zusätzlicher Dämpfungs- bzw. Kopplungsbereich vorgesehen werden.

Die **Fig. 2** und **3** zeigen unterschiedliche Ansichten der in **Fig.1** dargestellten Halbleiterlaserdiode 10. Diese sollen insbesondere die laterale Ausbildung der Gitterstrukturelemente 14 verdeutlichen.

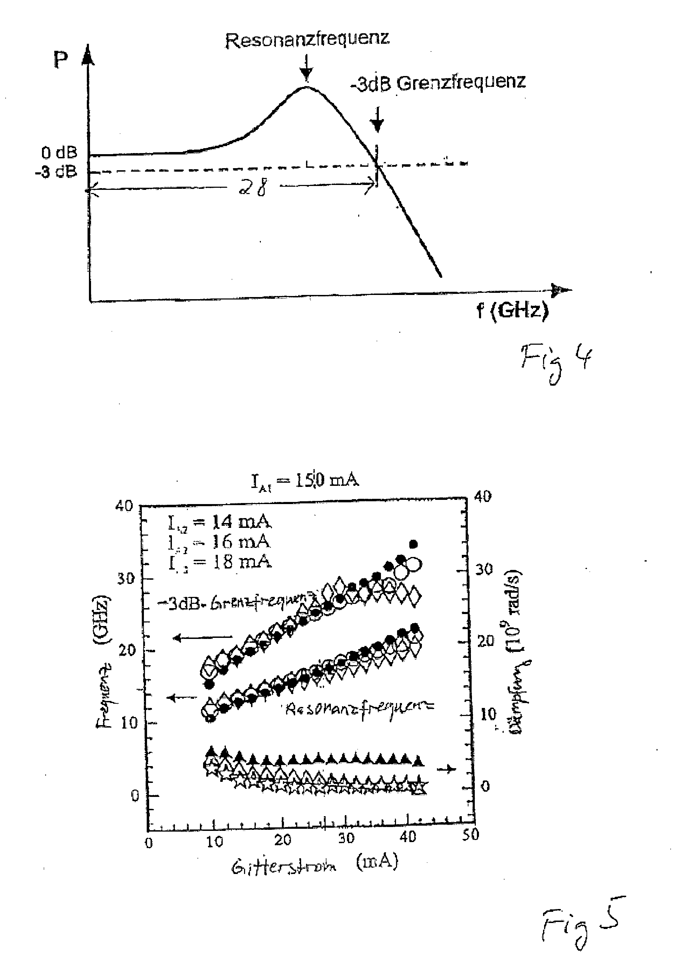

In **Fig. 4** ist ein typischer Verlauf der Ausgangsleistung P eines Halbleiterlasers bei Kleinsignalmodulation in Abhängigkeit von der Frequenz f des Modulationssignals schematisch dargestellt. Die maximale Modulationsfrequenz wird im Wesentlichen von der Rekombinationszeit der Ladungsträger in der aktiven Schicht bestimmt. Diese Rekombinationszeit hängt von den Materialeigenschaften und der Wechselwirkungsstärke des Elektron-Lochübergangs mit dem elektromagnetischen Strahlungsfeld in der Laserkavität ab. Die entsprechende Resonanzfrequenz wird als Elektron-Photon-Resonanz bezeichnet und gibt an, mit welcher Zeitkonstante die ausgekoppelte Lichtleistung auf Änderungen der induzierten Ladungsträgerdichte, also dem Modulationsstrom I_{mod} reagiert. Aufgrund von elektrischen und optischen Verlusten ist die Amplitude der Eigenfrequenz gedämpft. Oberhalb der Resonanzfrequenz fᵣₑₛ fällt die Ausgangsleistung P stark ab.

Die Modulationsbandbreite wird definiert über die maximale Frequenz, bei der die Amplitude der modulierten Lichtausgangsleistung P auf die Hälfte des Wertes im Dauerstrichbetrieb ("continuous wave") abgefallen ist (-3 dB Grenzfrequenz).

Neben der Elektron-Photon-Resonanz tritt aber in optischen Kavitäten auch eine sogenannte Photon-Photon-Resonanz auf, die durch die Konstruktivüberlagerung von hin- und rücklaufender Welle im Resonanzkörper entsteht. Diese Photon-Photon-Resonanz hängt im Wesentlichen nur von der Umlaufzeit eines Photons in der Laserkavität ab und ist im Wesentlichen unabhängig von den Betriebsparametern. Sie kann über die Bauelementlänge eingestellt werden. Die typische Umlauffrequenz bei einem 1 mm langen Laser liegt bei ca. 44 GHz. Eine Restabhängigkeit verbleibt jedoch, da z. B. die Resonanzfrequenz geringfügig vom Injektionsstrom abhängt, was jedoch an der Größenordnung der Resonanzfrequenz nichts ändert. Durch diesen üblicherweise im Promillebereich liegenden Effekt kann z.B. die Phasenlage eingestellt werden.

In **Fig. 5** sind Messungen für einen Prototyp der beschriebenen Halbleiterlaserdiode 10 dargestellt. Die Halbleiterlaserdiode 10 wurde basierend auf Indiumphosphid (InP) mit einer Länge von 1,1 mm gefertigt. Die Halbleiterlaserdiode 10 wurde mit einem Injektionsstrom I₁ = 150 mA und einer Modulationsstromamplitude I_{mod} = 12,5 mA bei Raumtemperatur betrieben. Die Emissionswellenlänge betrug 1,5 µm.

In **Fig. 5** sind jeweils die -3 dB-Grenzfrequenz, die Resonanzfrequenz fᵣₑₛ und die Dämpfung in Abhängigkeit vom Gitterstrom I_{Gitter} dargestellt. Dabei wurden jeweils drei unterschiedliche Phasenanpassungsströme I₂ mit I_{2 =}14 mA, I₂ = 16 mA und I₂ = 18 mA verwendet.

Generell nimmt mit zunehmendem Gitterstrom I_{Gitter} für alle dargestellten Phasenanpassungsströme I₂ die Resonanzfrequenz und die Bandbreite (-3 dB-Grenzfrequenz) der Halbleiterlaserdiode 10 kontinuierlich zu.

Durch Reduktion des Anpassungsstroms I₂ wurde vorliegend eine verbesserte Phasenanpassung erreicht, die bereits eine ca. 10%ige Erhöhung der Resonanzfrequenz bewirkte. Gleichzeitig wurde durch Erhöhung der beiden Ströme I₂ und I_{Gitter} die Dämpfung reduziert. Bei dem gemessenen Prototyp kann man die -3 dB-Bandbreite auf 34 GHz abschätzen, was um ca. einen Faktor 4 größer ist als bei einem vergleichbar langen konventionellen Laser mit den gleichen Schichteigenschaften.

Es ist zu erwähnen, dass der verwendete Messaufbau nur eine begrenzte Bandbreite auflösen konnte und daher die Werte der -3 dB-Grenzfrequenz oberhalb von 20 GHz nur über Anpassungskurven ermittelt werden konnten. Die scheinbare Sättigung der Bandbreite für einen Phasenanpassungsstrom von I₂ = 18 mA ist ein Artefakte der auf Probleme mit der Anpassung zurückzuführen ist.

Neueste Messungen an vergleichbaren Mehrsektionslasern mit einem Versuchsaufbau größerer Bandbreite (Bandbreite von 40 GHz) ergaben für einen 1,5 mm langen InP-basierten Halbleiterlaser eine tatsächliche Modulationsbandbreite von 37 GHz. Dieser Wert übertrifft den Wert für einen vergleichbaren herkömmlichen Streifenwellenleiterlaser um ca. das 4,5-fache und stellt einen Rekordwert für InP-basierte Laser dar.

## Patentansprüche

1. Halbleiterlaser (10), insbesondere mit hoher Modulationsbandbreite, mit einer Kopplung zwischen Elektron-Photon-Resonanz und Photon-Photon-Resonanz, mit einem Substrat (11), bei dem wenigstens drei voneinander unabhängige
Funktionssektionen (17, 20, 23) wie Verstärkungszone (17), Gitterzone (20) und Phasenanpassungszone (23), in Richtung der Lichtwellen-Ausbreitungsrichtung (A) vorgesehen sind, **gekennzeichnet durch** eine Gitterzone (20) mit schwacher Kopplung zwischen Lichtwelle (A) und Gitterstruktur (29), mit einem Kopplungskoeffizient κ < 60 cm⁻¹,
und **gekennzeichnet durch** eine Bauteillänge von mehr als 0,8 mm.

2. Halbleiterlaser nach Anspruch 1,
**gekennzeichnet durch** einen Kopplungskoeffizient κ zwischen 20 cm⁻¹ und 40 cm⁻¹,
und **gekennzeichnet durch** eine Bauteillänge von mehr als 1,0 mm.

3. Halbleiterlaser nach Anspruch 1,
**gekennzeichnet durch**
eine aktive Gitterzone (20) und/oder eine aktive Kopplungszone.

4. Halbleiterlaser nach Anspruch 1,
**dadurch gekennzeichnet, dass** bei den wenigstens drei voneinander unabhängigen Funktionssektionen (17, 20, 23) eine Ladungsträger-Rekombinationszone aus einer oder mehreren Schichten (30) eingebettet ist, die für die optische Verstärkung des Halbleiterlasers (10) sorgt.

5. Halbleiterlaser nach Anspruch 1,
**dadurch gekennzeichnet,**
**dass** das Substrat (11) als Monolith ausgebildet ist.

6. Halbleiterlaser nach einem der voranstehenden Ansprüche,
**dadurch gekennzeichnet,**
**dass** wenigstens ein Wellenleiterbereich (13) vorgesehen ist.

7. Halbleiterlaser nach einem der voranstehenden Ansprüche,
**dadurch gekennzeichnet,**
**dass** die Funktionssektionen (17, 20, 23) im Wesentlichen nur jeweils eine Funktion ausüben.

8. Halbleiterlaser nach einem der voranstehenden Ansprüche,
**dadurch gekennzeichnet,**
**dass** eine Gitterzone (20) und/oder eine Kopplungszone zwischen einer Verstärkungszone (17) und einer Phasenanpassungszone (23) liegend angeordnet sind.

9. Halbleiterlaser nach Anspruch 1,
**dadurch gekennzeichnet, dass** die Gitterstruktur durch einen fokussierten lonenstrahl eingeprägt wurde.

10. Halbleiterlaser nach einem der voranstehenden Ansprüche,
**dadurch gekennzeichnet,**
**dass** die Gitterstrukturen (14) lateral zum Wellenleiterbereich (13) ausgebildet sind.

11. Verfahren zum Betrieb eines Halbleiterlasers nach Anspruch 1, bei dem unterschiedliche Aufgaben, wie insbesondere Verstärkung (17), Phasenanpassung (23), Wellenlängenselektion (20) und/oder Dämpfung (20), in wenigstens drei voneinander unabhängigen Sektionen längs des Substratmaterials (11) des Halbleiterlasers (10) durchgeführt werden,
und **dadurch gekennzeichnet,**
**dass** eine zweite Sektion, die als Gitterzone dient, in Richtung der Lichtwellen-Ausbreitungsrichtung zwischen einer ersten Sektion und einer dritten Sektion liegt,
wobei die erste Sektion als Verstärkungs- und Modulationszone dient, und **dadurch gekennzeichnet,**
**dass** der ersten Sektion ein Injektionsstrom I₁ sowie ein Modulationsstrom I_{mod} zugeführt wird.

12. Verfahren nach Anspruch 11,
**dadurch gekennzeichnet,**
**dass** der Halbleiterlaser (10) auf der langwelligen Seite des Reflexionspeaks betrieben wird.

## Claims

1. A semiconductor laser (10), particularly with a high modulation bandwidth, with a coupling between electron-photon resonance and photon-photon resonance, with a substrate (11), in which three mutually independent function sections (17, 20, 23), such as amplification zone (17), grid zone (20) and phase adjustment zone (23), are provided in the direction of the light-wave propagation direction (A), **characterised by** a grid zone (20) with weak coupling between light wave (A) and grid structure (29), with a coupling coefficient κ ≤ 60 cm⁻¹, and **characterised by** a component length of more than 0.8 mm.

2. The semiconductor laser according to Claim 1,
**characterised by** a coupling coefficient κ between 20 cm⁻¹ and 40 cm⁻¹, and **characterised by** a component length of more than 1.0 mm.

3. The semiconductor laser according to Claim 1,
**characterised by**
an active grid zone (20) and/or an active coupling zone.

4. The semiconductor laser according to Claim 1,
**characterised in that** a charge-carrier recombination zone made up of one or a plurality of layers (30) is embedded in the at least three mutually independent function sections (17, 20, 23), which takes care of the optical amplification of the semiconductor laser (10).

5. The semiconductor laser according to Claim 1,
**characterised**
**in that** the substrate (11) is constructed monolithically.

6. The semiconductor laser according to one of the preceding claims,
**characterised**
**in that** at least one waveguide area (13) is provided.

7. The semiconductor laser according to one of the preceding claims,
**characterised**
**in that** the function sections (17, 20, 23) essentially only perform one function in each case.

8. The semiconductor laser according to one of the preceding claims,
**characterised**
**in that** a grid zone (20) and/or a coupling zone are arranged lying between an amplification zone (17) and a phase adjustment zone (23).

9. The semiconductor laser according to Claim 1,
**characterised in that** the grid structure was imprinted by a focussed ion beam.

10. The semiconductor laser according to one of the preceding claims,
**characterised**
**in that** the grid structures (14) are constructed laterally to the waveguide area (13).

11. A method for operating a semiconductor laser according to Claim 1, in which different tasks, such as in particular amplification (17), phase adjustment (23), wavelength selection (20) and/or damping (20) are carried out in at least three mutually independent sections along the substrate material (11) of the semiconductor laser (10),
and **characterised**
**in that** a second section, which is used as grid zone, lies between a first section and a third section in the direction of the light-wave propagation direction,
wherein the first section is used as amplification and modulation zone, and **characterised**
**in that** an injection current I₁ and a modulation current I_{mod} are supplied to the first section.

12. The method according to Claim 11,
**characterised**
**in that** the semiconductor laser (10) is operated on the long-wave side of the reflection peak.

## Revendications

1. Laser à semi-conducteur (10), en particulier avec une largeur de bande de modulation importante, avec un couplage entre la résonance électron/photon et la résonance photon/photon, avec un substrat (11) pour lequel on prévoit au moins trois sections fonctionnelles (17, 20, 23) indépendantes les unes des autres, telles une zone de renforcement (17), une zone de réseau (20) et une zone d'adaptation de phase (23), en direction de propagation des ondes lumineuses (A), **caractérisé par** une zone de réseau (20) à faible couplage entre l'onde lumineuse (A) et la structure de réseau (29), avec un coefficient de couplage κ ≤ 60 cm⁻¹,
et **caractérisé par** une longueur d'élément constitutif de plus de 0,8 mm.

2. Laser à semi-conducteur selon la revendication 1,
**caractérisé par** un coefficient de couplage κ compris entre 20 cm⁻¹ et 40 cm⁻¹,
et **caractérisé par** une longueur d'élément constitutif de plus de 1,0 mm.

3. Laser à semi-conducteur selon la revendication 1,
**caractérisé par**
une zone de réseau (20) active et/ou une zone de couplage active.

4. Laser à semi-conducteur selon la revendication 1, **caractérisé en ce que**, pour ces au moins trois sections fonctionnelles (17, 20, 23) indépendantes les unes des autres, une zone de recombinaison de porteur de charge en une ou plusieurs couches (30) est insérée, laquelle assure le renforcement optique du laser à semi-conducteur (10).

5. Laser à semi-conducteur selon la revendication 1,
**caractérisé en ce que**
le substrat (11) est réalisé en tant que monolithe.

6. Laser à semi-conducteur selon l'une des revendications précédentes,
**caractérisé en ce que**
l'on prévoit au moins une zone de guide d'onde (13).

7. Laser à semi-conducteur selon l'une des revendications précédentes,
**caractérisé en ce que**
les sections fonctionnelles (17, 20, 23) exercent sensiblement seulement une fonction respective.

8. Laser à semi-conducteur selon l'une des revendications précédentes,
**caractérisé en ce qu'**
une zone de réseau (20) et/ou une zone de couplage est disposée de manière à se situer entre une zone de renforcement (17) et une zone d'adaptation de phase (23).

9. Laser à semi-conducteur selon la revendication 1,
**caractérisé en ce que**
la structure de réseau a été incrustée grâce à un faisceau ionique focalisé.

10. Laser à semi-conducteur selon l'une des revendications précédentes,
**caractérisé en ce que**
les structures de réseau (14) sont réalisées latéralement par rapport à la zone de guide d'onde (13).

11. Procédé pour l'exploitation d'un laser à semi-conducteur selon la revendication 1,
dans lequel différentes tâches, telles en particulier le renforcement (17), l'adaptation de phase (23), la sélection de la longueur d'onde (20) et/ou l'atténuation (20) sont exécutées dans au moins trois sections indépendantes les unes des autres le long du matériau de substrat (11) du laser à semi-conducteur (10),
et **caractérisé en ce qu'**
une deuxième section, laquelle sert de zone de réseau, se situe en direction du sens de propagation d'onde lumineuse entre une première section et une troisième section,
la première section servant de zone de renforcement et de modulation,
et **caractérisé en ce qu'**
un courant d'injection I₁ ainsi qu'un courant de modulation I_{mod} est amené à la première section.

12. Procédé selon la revendication 11,
**caractérisé en ce que**
le laser à semi-conducteur (10) est exploité du côté d'onde longue du pic de réflexion.
